# FASCICULE DE BREVET EUROPEEN

(11) **EP 0 889 679 B1**
(45) Date de publication et mention de la délivrance du brevet: **17.09.2003**
(21) Numéro de dépôt: 98401652.7
(22) Date de dépôt: 02.07.1998
(51) Int. Cl.: H05K 1/11

(54) **Plage de contact de circuit imprimé pour connecteur à pince**
Leiterplattenkontaktfläche für Klemmverbinder
Printed circuit contact pad for pinch connector

(30) Priorité: 04.07.1997 FR 9708495
(43) Date de publication de la demande: 07.01.1999
(73) Titulaire: CROUZET APPLIANCE CONTROLS, F-26120 Montelier Chabeuil (FR)
(72) Inventeur: Astic, Georges, 26320 St. Marcel les Valence (FR)
(74) Mandataire: Geismar, Thierry

(56) Documents cités:
- "Dust collector for PC I/O tab" IBM TECHNICAL DISCLOSURE BULLETIN., vol. 30, no. 8, janvier 1988, pages 352-353, XP002041986 NEW YORK US
- PATENT ABSTRACTS OF JAPAN vol. 18, no. 318 (E-1562), 16 juin 1994 & JP 06 069619 A (FUJITSU), 11 mars 1994

## Description

La présente invention concerne une plage de contact de circuit imprimé pour connecteur à pince.

Actuellement, de nombreuses cartes électroniques sont connectées aux systèmes environnants par l'intermédiaire de dispositifs de connexion économiques du type dit "connecteur bord de carte". Ces connecteurs sont constitués d'un boîtier en matière plastique dans lequel sont retenues des pinces élastiques métalliques ayant pour fonction d'établir le contact avec le circuit imprimé sur des plages de contact généralement appelées PADS qui sont disposées en bordure de la carte. Ces plages sont formées par le cuivre du circuit imprimé dont l'épaisseur est typiquement de 17,5 µm, 35 µm, 70 µm ou 105 µm.

Ces pinces métalliques sont agencées pour enserrer le circuit imprimé dans le sens de son épaisseur (en général de 1,5 mm), et pour recevoir dans leur partie arrière un fil conducteur isolé maintenu soit par sertissage, soit par pénétration directe (technique dite par "déplacement d'isolant"). Le circuit lui-même peut être à une face ou à deux faces de cuivre.

Le boîtier du connecteur contient un certain nombre de pinces et comporte des parois internes qui, en combinaison avec des encoches pratiquées en bordure du circuit imprimé, servent de détrompage pour éviter les erreurs d'assemblage.

Il arrive que l'on rencontre des défauts de contact avec ce type de connecteurs. Ces défauts sont généralement dus à des impuretés arrachées par la pince sur le bord du circuit imprimé lors de l'insertion du connecteur.

En fait, c'est le plus souvent l'action d'écartement de la pince élastique sur la bordure du circuit imprimé qui provoque de petits éclatements du substrat isolant constituant le circuit. Ces éclatements se produisent d'autant plus que le substrat est de moins bonne qualité.

La présente invention vise à pallier ces inconvénients.

A cet effet, l'invention a pour objet une plage de contact de circuit imprimé pour connecteur à pince, caractérisée par le fait qu'elle comporte au moins une gravure formant une arête de nettoyage transversalement à la direction de mise en place du connecteur sur le circuit imprimé.

La plage de contact étant formée de cuivre rapporté sur le substrat isolant du circuit imprimé, la gravure se présente comme une réserve en creux dont le bord le plus éloigné dans la direction de mise en place du connecteur forme l'arête de nettoyage. Ainsi, les impuretés présentes entre la pince et le circuit imprimé sont retenues par cette arête et déposées dans la partie en creux de la gravure.

On observera que, par transversalement, on entend qui ne soit pas parallèle à la direction de mise en place, de manière à effectuer un grattage efficace de la surface de la pince lors de son passage sur la gravure. Mais il n'est pas nécessaire que l'arête soit perpendiculaire à la direction de mise en place du connecteur. On verra qu'on adopte en fait de préférence des gravures inclinées par rapport à cette direction.

Dans un mode de réalisation, la plage de contact comprend une pluralité de gravures alignées dans la direction de mise en place du connecteur sur le circuit imprimé.

De préférence, les gravures ont une forme en V, dont la pointe est dirigée dans la direction opposée à celle de mise en place du connecteur.

Cette forme présente tout d'abord l'avantage d'être efficace pour le nettoyage de la surface de la pince des impuretés qui pourraient y adhérer.

Les gravures en V permettent en outre de diminuer très sensiblement l'épaisseur de la "goutte" d'étamage laissée à l'extrémité de la plage de contact lors du processus d'étamage au rouleau. La formation de cette goutte est un phénomène bien connu qui provoque une surépaisseur pouvant aller jusqu'à 0,1 mm, alors que la couche d'étain n'est que d'environ 5µm. Cette surépaisseur est très gênante lors de la mise en place du connecteur sur le circuit imprimé.

Les gravures en V ont pour effet de parcelliser la surface de base de la goutte et, ainsi de diminuer sa hauteur. La forme des gravures a en outre pour résultat de drainer l'étain vers l'extérieur de la plage, à un emplacement où il est moins gênant.

De préférence, la largeur des gravures est telle, en fonction du rayon de courbure de la pince et de l'épaisseur du cuivre, que la surface de la pince ne puisse arriver au contact du substrat isolant lorsque la pince est en face d'une telle gravure.

Un calcul géométrique élémentaire permet de déterminer la largeur maximale de la gravure. Ainsi, même dans le cas où la pince serait incomplètement engagée sur le circuit imprimé, le contact serait assuré.

On décrira maintenant, à titre d'exemple non limitatif, un mode de réalisation particulier de l'invention, en référence aux dessins schématiques annexés dans lesquels :
- la figure 1 est une vue de dessus d'un circuit imprimé comportent des plages de contact selon l'invention;
- la figure 2 est une vue en coupe à plus grande échelle d'un connecteur monté sur un tel circuit;
- la figure 3 est une vue de dessus à encore plus grande échelle d'une plage de contact selon l'invention; et
- la figure 4 est une vue en coupe selon la ligne IV-IV de la figure 3 représentant en outre une pince de connecteur.

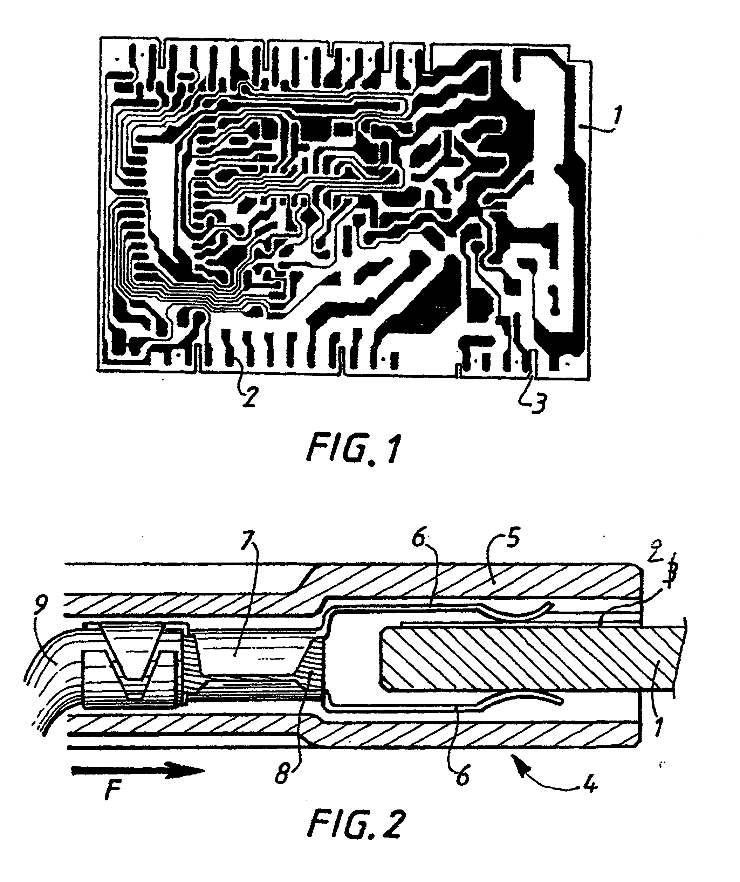

On voit à la figure 1 un circuit imprimé 1 muni de plages de contact 2 pour sa connexion à son environnement. Cette connexion est réalisée au moyen de connecteurs dits "bord de carte" montés comme cela sera décrit ci-après le long de la bordure du circuit. Des encoches 3 le long de cette bordure coopèrent avec des parois des connecteurs pour n'autoriser qu'un montage convenable de ces derniers.

Les plages de contact sont formées, comme les pistes conductrices du circuit, de cuivre déposé aux emplacements convenables, par exemple en 35 µm d'épaisseur. Elles arrivent à proximité du bord du circuit pour coopérer avec les pinces des connecteurs que l'on décrira maintenant en référence à la figure 2.

Un connecteur 4 comprend un boîtier 5 en matière plastique maintenant des pinces élastiques métalliques 6 agencées pour enserrer le circuit imprimé 1. A cet effet, les extrémités des branches des pinces 6 sont recourbées en forme de patins. Les branches des pinces 6 viennent dans ces conditions en contact avec les plages de contact 2. Les pinces 6 sont électriquement reliées à une douille 7 dans laquelle est sertie l'extrémité 8 d'un fil de connexion 9 qui assure la liaison avec l'environnement extérieur du circuit imprimé 1.

Le montage du connecteur 4 sur le circuit imprimé s'effectue en l'engageant sur ce dernier dans la direction des flèches F des figures 2 à 4. Dans ce mouvement, les branches des pinces 6 sont écartées par le bord du circuit imprimé du fait de leur arrondi, mais il peut arriver que des impuretés soient arrachées du substrat isolant du circuit et viennent s'interposer entre les pinces et les plages de contact 2. La liaison n'est alors plus assurée convenablement.

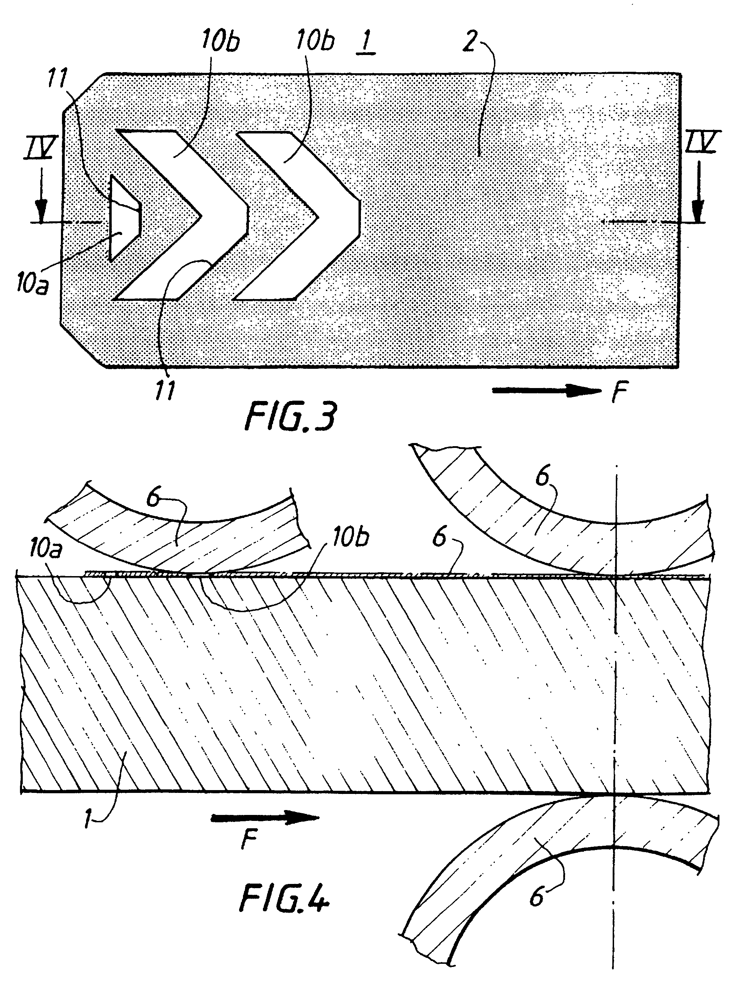

Afin d'éliminer ces impuretés, les plages de contact 2 comportent, selon l'invention, des gravures 10, c'est-à-dire des zones non métallisées, donc en creux par rapport à la surface du cuivre des plages 2. Dans le mode de réalisation de la figure 3, la plage de contact comporte, dans la direction de mise en place F du connecteur, une première gravure trapézoïdale 10a, et successivement deux gravures en V, ou en chevrons, 10b. Les branches des V sont ici inclinées sensiblement à 45° par rapport à la direction F.

Les gravures 10 forment ainsi des arêtes de nettoyage 11 faisant face au connecteur 4 lors de son introduction, et assurent une fonction de décapage des surfaces des pinces 6. Les impuretés sont donc éliminées.

On voit en traits mixtes à la figure 4, une des branches d'une pince 6 du connecteur en cours de mise en place. A l'instant où la pince 6 passe sur une gravure, la largeur de cette dernière est suffisamment faible en fonction du rayon de courbure de la pince et de l'épaisseur du cuivre, pour que la pince ne puisse venir en contact avec le substrat isolant du circuit imprimé 1. La continuité électrique est ainsi toujours assurée.

## Revendications

1. Plage de contact (2) de circuit imprimé (1) pour connecteur à pince, **caractérisée par le fait qu'**elle comporte au moins une gravure (10a, 10b) formant une arête de nettoyage transversalement à la direction (F) de mise en place du connecteur sur le circuit imprimé (1).

2. Plage de contact selon la revendication 1, dans laquelle la plage de contact (2) comprend une pluralité de gravures (10a, 10b) alignées dans la direction de mise en place du connecteur sur le circuit imprimé (1).

3. Plage de contact selon l'une quelconque des revendications 1 et 2, dans laquelle les gravures (10a, 10b) ont une forme en V, dont la pointe est dirigée dans la direction opposée à celle de mise en place du connecteur.

4. Plage de contact selon l'une quelconque des revendications 1 à 3, dans laquelle la largeur des gravures (10a, 10b) est telle, en fonction du rayon de courbure de la pince (6) et de l'épaisseur du cuivre, que la surface de la pince ne puisse arriver au contact du substrat isolant lorsque la pince (6) est en face d'une telle gravure (10a, 10b).

## Patentansprüche

1. Kontaktfläche (2) einer gedruckten Schaltung (1) für Klemmenstecker, **dadurch gekennzeichnet, dass** sie mindestens eine Gravur (10a, 10b) aufweist, die eine Reinigungskante quer zur Einsatzrichtung (F) des Steckers auf der gedruckten Schaltung (1) bildet.

2. Kontaktfläche nach Anspruch 1, bei der die Kontaktfläche (2) eine Mehrzahl von in Einsatzrichtung des Steckers auf der gedruckten Schaltung (1) verlaufenden Gravuren (10a, 10b) umfasst.

3. Kontaktfläche nach einem der Ansprüche 1 und 2, bei der die Gravuren (10a, 10b) V-förmig sind, dessen Spitze in die der Einsatzrichtung des Steckers gegenüberliegende Richtung zeigt.

4. Kontaktfläche nach einem der Ansprüche 1 bis 3, bei der die Breite der Gravuren (10a, 10b) je nach Krümmungsradius der Klemme (6) und Dicke des Kupfers so bemessen ist, dass die Oberfläche der Klemme nicht mit dem isolierenden Substrat in Kontakt treten kann, wenn sich die Klemme (6) gegenüber einer derartigen Gravur (10a, 10b) befindet.

## Claims

1. A contact area (2) on a printed circuit (1) for a clamp connector, **characterised by** the fact that it comprises at least one etching (10a, 10b) forming a cleaning edge transversely to the direction (F) of fitting the connector on the printed circuit (1).

2. A contact area according to Claim 1, in which the contact area (2) comprises a plurality of etchings (10a, 10b) aligned in the direction of fitting the connector on the printed circuit (1).

3. A contact area according to either one of Claims 1 and 2, in which the etchings (10a, 10b) have a V-shape, whose apex is directed in the opposite direction to that of the fitting of the connector.

4. A contact area according to any one of Claims 1 to 3, in which the width of the etchings (10a, 10b) is such, as a function of the radius of curvature of the clamp (6) and the thickness of the copper, that the surface of the clamp cannot come into contact with the insulating substrate when the clamp (6) is facing such an etching (10a, 10b).
